# FASCICULE DE BREVET EUROPEEN

(11) **EP 3 568 868 B1**
(45) Date de publication et mention de la délivrance du brevet: **21.06.2023**
(21) Numéro de dépôt: 18702752.9
(22) Date de dépôt: 10.01.2018
(51) Int. Cl.: H01L 21/20, H01L 27/146, H01L 21/762, H01L 31/028, H01L 31/052

(54) **SUBSTRAT POUR CAPTEUR D'IMAGE DE TYPE FACE AVANT ET PROCÉDÉ DE FABRICATION D'UN TEL SUBSTRAT**
SUBSTRAT FÜR EINEN -BILDSENSOR VOM FRONTSEITENTYP UND VERFAHREN ZUR HERSTELLUNG SOLCH EINES SUBSTRATS
SUBSTRATE FOR A FRONT-SIDE-TYPE IMAGE SENSOR AND METHOD FOR PRODUCING SUCH A SUBSTRATE

(30) Priorité: 11.01.2017 FR 1750237
(43) Date de publication de la demande: 20.11.2019
(73) Titulaire: Soitec, 38190 Bernin (FR)
(72) Inventeur: SCHWARZENBACH, Walter, 38330 Saint Nazaire les Eymes (FR); KONONCHUK, Oleg, 38570 Theys (FR); ECARNOT, Ludovic, 38000 Grenoble (FR); MICHAU, Christelle, 38190 Bernin (FR)
(74) Mandataire: Regimbeau
(86) Numéro de dépôt international: PCT/FR2018/050053
(87) Numéro de publication internationale: WO 2018/130780

(56) Documents cités:
- WO-A1-2005/078786
- WO-A2-2005/043614
- WO-A2-2005/043614
- FR-A1- 2 789 517
- FR-A1- 2 789 517
- JP-A- 2008 305 994
- US-A1- 2004 242 006
- US-A1- 2012 068 289
- HUANG L J ET AL: "SiGe-on-insulator prepared by wafer bonding and layer transfer for high-performance field-effect transistors", APPLIED PHYSICS LETTERS, A I P PUBLISHING LLC, US, vol. 78, no. 9, 26 février 2001 (2001-02-26), pages 1267-1269, XP012028719, ISSN: 0003-6951, DOI: 10.1063/1.1342212
- NAKAHARAI S ET AL: "CHARACTERIZATION OF 7-NM-THICK STRAINED GE-ON-INSULATOR LAYER FABRICATED BY GE-CONDENSATION TECHNIQUE", APPLIED PHYSICS LETTERS, A I P PUBLISHING LLC, US, vol. 83, no. 17, 27 octobre 2003 (2003-10-27), pages 3516-3518, XP001192557, ISSN: 0003-6951, DOI: 10.1063/1.1622442

## Description

### DOMAINE DE L'INVENTION

La présente invention concerne un substrat pour capteur d'image de type « face avant », un capteur d'image incorporant un tel substrat, et un procédé de fabrication d'un tel substrat.

### ETAT DE LA TECHNIQUE

Le document US 2016/0118431 décrit un capteur d'image de type « face avant » (« front-side imager », selon la terminologie anglo-saxonne).

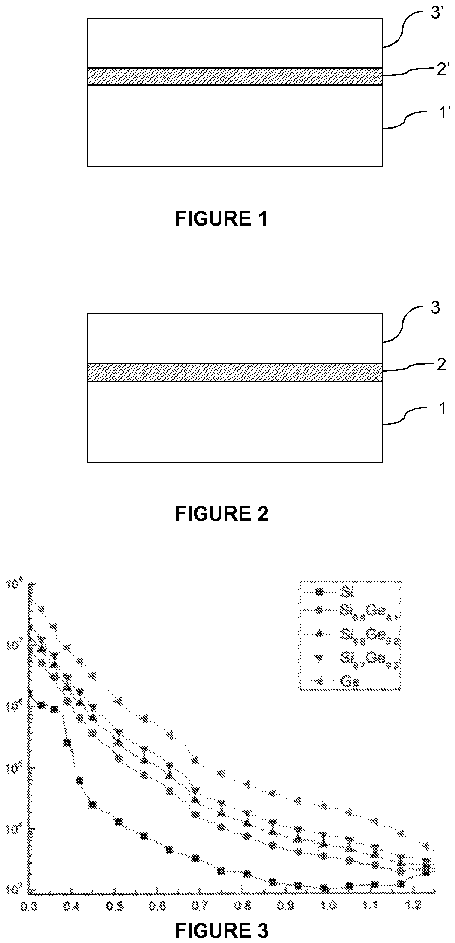

Comme illustré sur la figure 1, ledit capteur comprend un substrat de type semi-conducteur sur isolant (SOI, acronyme du terme anglo-saxon « Semiconductor-On-Insulator ») comprenant, de sa face arrière vers sa face avant, un substrat support 1' de silicium présentant un certain dopage, une couche 2' d'oxyde de silicium, et une couche 3' dite couche active de silicium monocristallin présentant un dopage pouvant être différent de celui du substrat support 1', dans laquelle est défini un réseau matriciel de photodiodes définissant chacune un pixel.

Toutefois, un tel capteur présente une faible sensibilité dans le proche infrarouge, c'est-à-dire pour des longueurs d'onde comprises entre 700 nm et 3 µm.

En effet, la couche active 3' de silicium présente un coefficient d'absorption qui décroît fortement avec la longueur d'onde d'un rayonnement auquel elle est exposée, à savoir d'environ 10⁶ cm⁻¹ pour une longueur d'onde de 300 nm à quelques 10³ cm⁻¹ à partir de 700 nm.

Cependant, le silicium monocristallin est à ce jour le matériau privilégié pour former la couche active du substrat pour le capteur d'image, car il présente l'avantage d'être compatible avec les procédés de microélectronique permettant la fabrication du capteur, et de présenter une qualité cristalline (notamment une absence de dislocations) adaptée à la fonction de la couche active.

US2003127646, considéré comme état de l'art le plus proche de l'invention, concerne un procédé de dépôt de Ge/SiGe sur SOI suivi par mixage thermique puis réépitaxie SiGe pour produire une couche SiGe épaisse.

### EXPOSE DE L'INVENTION

Un but de l'invention est de remédier au problème susmentionné et de proposer un substrat pour capteur d'image de type « face avant » qui permette d'augmenter l'absorption de lumière dans le proche infrarouge tout en respectant les contraintes de compatibilité avec le procédé de fabrication du capteur d'image et de qualité cristalline de la couche active.

A cet effet, l'invention propose un procédé de fabrication d'un substrat pour un capteur d'image de type face avant, selon la revendication 1.

### DESCRIPTION DES FIGURES

D'autres caractéristiques et avantages de l'invention apparaîtront à la lecture de la description détaillée qui va suivre, en référence aux dessins annexés sur lesquels :
- la figure 1 est une vue en coupe d'un substrat SOI pour capteur d'image face avant tel que décrit dans le document US 2016/0118431 ;
- la figure 2 est une vue en coupe d'un substrat selon un exemple utile pour comprendre l'invention;
- la figure 3 présente le coefficient d'absorption du silicium-germanium en fonction de la longueur d'onde pour différentes teneur en germanium ;
- la figure 4 présente l'épaisseur critique d'une couche de silicium-germanium en fonction de sa teneur en germanium ;
- la figure 5 est une vue en coupe d'un substrat conforme à une variante de réalisation de l'invention ;
- les figures 6A à 6F illustrent les principales étapes d'un procédé de fabrication d'un substrat pour capteur d'image face avant selon un exemple utile pour comprendre l'invention;
- les figures 7A à 7C illustrent des étapes d'un exemple utile pour comprendre l'invention illustré sur les figures 6A à 6F ;
- les figures 8A à 8D illustrent les principales étapes d'un procédé de fabrication d'un substrat pour capteur d'image face avant selon un mode de réalisation de l'invention ;
- la figure 9 est une vue en coupe d'un substrat conforme à une forme d'exécution particulière de l'invention,
- la figure 10 illustre la réflectivité d'un empilement de couches diélectriques en fonction de la longueur d'onde (en nm),
- les figures 11A à 11E illustrent les principales étapes d'un procédé de fabrication d'un substrat pour capteur d'image face avant selon un mode de réalisation de l'invention,
- la figure 12 est une vue en coupe d'un pixel d'un capteur d'image de type « face avant » comprenant un substrat selon un mode de réalisation de l'invention.

Pour des raisons de lisibilité des figures, les différentes couches ne sont pas nécessairement représentées à l'échelle.

### DESCRIPTION DETAILLEE DE L'INVENTION

La figure 2 est une vue en coupe d'un substrat pour un capteur d'image face avant selon un exemple utile pour comprendre l'invention.

Ledit substrat comprend successivement, de sa face arrière vers sa face avant, un substrat support 1 semi-conducteur, une couche électriquement isolante 2 et une couche 3 monocristalline de silicium-germanium (SiGe) dite couche active.

Le substrat support 1 est généralement obtenu par découpe d'un lingot monocristallin. De manière avantageuse, le substrat 1 est en silicium.

Selon un mode de réalisation, la couche électriquement isolante est une couche d'oxyde de silicium.

De manière avantageuse, l'épaisseur de ladite couche électriquement isolante est comprise entre 10 et 200 nm.

La couche 3 est destinée à recevoir un réseau matriciel de photodiodes (non représenté) permettant la capture d'images. L'épaisseur de la couche 3 est typiquement supérieure ou égale à 1 µm, voire supérieure à 2 µm. Ladite couche 3 peut être légèrement dopée.

Comme on peut le voir sur la figure 3, qui illustre le coefficient d'absorption (en cm⁻¹) du SiGe en fonction de la longueur d'onde (en µm) pour différentes compositions dudit matériau, le coefficient d'absorption, notamment dans l'infrarouge, augmente avec la teneur en germanium.

Cependant, la conception de la couche 3 ne porte pas que sur la concentration en germanium mais aussi sur l'épaisseur de ladite couche. En effet, la couche de SiGe étant formée par épitaxie sur un substrat de silicium, dont le paramètre de maille est différent de celui du silicium-germanium, il se produit une relaxation de la couche de SiGe au-delà d'une certaine épaisseur, dite épaisseur critique. Cette relaxation se traduit par la formation de dislocations au sein de la couche de SiGe.

De telles dislocations rendraient la couche de SiGe impropre à la fonction de la couche active 3 et doivent donc être évitées.

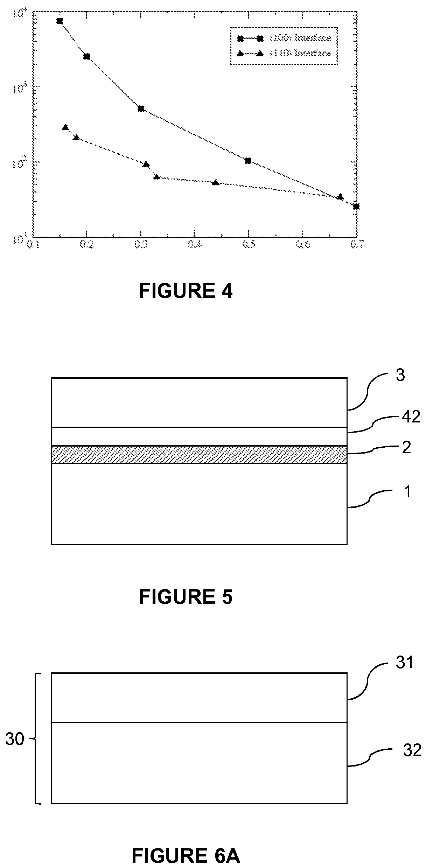

Comme le montre la figure 4, qui illustre l'épaisseur critique (en Å) d'une couche de SiGe en fonction de la teneur en germanium (coefficient stœchiométrique x correspondant à la composition Si₁₋ₓ Geₓ), l'épaisseur critique est d'autant plus faible que la concentration en germanium est élevée.

L'épaisseur de la couche active 3 et la concentration en germanium de ladite couche résultent donc d'un compromis entre :
- d'une part, une épaisseur suffisamment grande pour capturer un maximum de photons dans les longueurs d'onde du proche infrarouge,
- d'autre part, une concentration suffisante en germanium pour accroître la capacité d'absorption des photons par la couche active en particulier dans le proche infrarouge, et
- une épaisseur limitée (dépendant de la concentration) pour éviter la relaxation du silicium-germanium et la création de défauts cristallins (dislocations) qui en résulte.

Typiquement, on cherche à maximiser l'épaisseur et la concentration en germanium de la couche 3 pour avoir la meilleure absorption possible dans l'infrarouge, tout en minimisant la présence de dislocations dans ladite couche active.

La teneur en germanium de la couche active est inférieure à 10%, de préférence inférieure ou égale à 8%. La figure 4 montre en effet que l'épaisseur critique d'une couche de Si_{0,9} Ge_{0,1} est de l'ordre du micromètre, ce qui convient à la couche active d'un capteur d'image de type « face avant ». Pour une couche de Si_{0,92}Ge_{0,08}, l'épaisseur critique est supérieure à 2 µm ; par ailleurs, le coefficient d'absorption à une longueur d'onde de 940 nm est trois à quatre fois supérieur à celui du silicium.

Par rapport à une couche de silicium-germanium formée par interdiffusion (« thermal mixing » selon la terminologie anglo-saxonne), telle que décrite dans le document WO 2005/043614, la couche active épitaxiale de silicium-germanium utilisée dans la présente invention présente une meilleure uniformité et un coût plus faible. En effet, l'obtention d'une couche de silicium-germanium par interdiffusion implique la formation d'un empilement constitué (depuis sa surface libre vers un substrat servant de support mécanique) d'une couche de silicium-germanium riche en germanium (par exemple avec une teneur de l'ordre de 80% en germanium), d'une couche épaisse de silicium (correspondant sensiblement à l'épaisseur souhaitée pour la couche de silicium-germanium finale) et une couche formant une barrière de diffusion des atomes de germanium, destinée à éviter la migration desdits atomes dans le substrat sous-jacent. Or, plus la couche de silicium est épaisse, plus la durée du procédé (incluant la durée d'épitaxie de ladite couche puis la durée du traitement thermique de la couche de silicium-germanium pour faire diffuser les atomes de germanium au sein de la couche de silicium) est grande. En pratique, ce procédé d'interdiffusion n'est donc pas adapté à la formation d'une couche active de l'ordre du micromètre nécessaire pour un capteur d'image. En tout état de cause, l'homme du métier saura distinguer une couche épitaxiale d'une couche formée par interdiffusion en mesurant la quantité de dislocations et la relaxation de ladite couche.

On va maintenant décrire des exemples de procédés de fabrication du substrat illustré sur la figure 2.

D'une manière générale, le procédé de fabrication d'un substrat comprend les étapes suivantes.

D'une part, on fournit un substrat donneur comprenant un matériau semi-conducteur adapté pour la croissance épitaxiale de silicium-germanium. Ledit matériau peut notamment être du SiGe (permettant une homoépitaxie) ou un matériau différent du SiGe mais présentant un paramètre de maille suffisamment proche de celui du SiGe pour permettre la croissance épitaxiale de celui-ci (hétéroépitaxie). Dans ce dernier cas, ledit matériau semi-conducteur est avantageusement du silicium.

D'autre part, on fournit un substrat receveur, et l'on colle le substrat donneur sur le substrat receveur, une couche électriquement isolante étant à l'interface de collage.

On amincit ensuite le substrat donneur de sorte à transférer une couche du matériau semi-conducteur sur le substrat receveur.

Cet amincissement peut être effectué par polissage ou gravure du matériau semi-conducteur de sorte à obtenir l'épaisseur et l'état de surface souhaité pour l'épitaxie du SiGe.

Toutefois, selon l'invention, on procède, avant l'étape de collage, à la formation d'une zone de fragilisation dans le matériau semi-conducteur de sorte à délimiter une couche superficielle à transférer. Après l'étape de collage, l'amincissement consiste à détacher le substrat donneur le long de la zone de fragilisation, ce qui conduit au transfert de la couche superficielle sur le substrat receveur. Typiquement, l'épaisseur de la couche transférée est inférieure ou égale à 400 nm. Eventuellement, on effectue un traitement de finition de la surface libre de la couche transférée afin de favoriser la mise en oeuvre de l'épitaxie, ce traitement pouvant conduire à amincir la couche transférée.

Enfin, on met en oeuvre, sur la couche de matériau semi-conducteur transférée, qui sert de couche germe, la croissance épitaxiale d'une couche de silicium-germanium jusqu'à l'obtention de l'épaisseur souhaitée pour la couche active.

On notera que il subsiste, à l'issue de l'épitaxie du SiGe, la couche germe de silicium sous la couche active 3.

Cette situation est illustrée sur la figure 5, qui correspond à un mode de réalisation de l'invention. La couche germe est désignée par le repère 42.

La couche germe est suffisamment mince (d'une épaisseur inférieure ou égale à 300 nm) par rapport à l'épaisseur de la couche active pour ne pas affecter notablement les propriétés de la couche active de SiGe en termes d'absorption dans l'infrarouge.

Cependant, il est possible de retirer la couche germe, par exemple au moyen d'un procédé de condensation. De manière connue en elle-même, ledit procédé comprend une oxydation de la couche de SiGe, ladite oxydation ayant pour effet de consommer uniquement le silicium (pour former de l'oxyde de silicium) et de faire migrer le germanium vers la face opposée à la surface libre de la couche de SiGe. On obtient alors en surface une couche de SiO₂ que l'on peut éliminer par gravure.

Selon un premier exemple, illustré sur les figures 6A à 6F, on part d'un substrat donneur 30 comprenant une couche superficielle 31 de SiGe.

Ladite couche de SiGe est typiquement formée par épitaxie sur un substrat de base 32, généralement en silicium. Ladite couche de SiGe est suffisamment mince pour être en contrainte.

Dans une première version de cet exemple, une zone de fragilisation est formée dans la couche de SiGe.

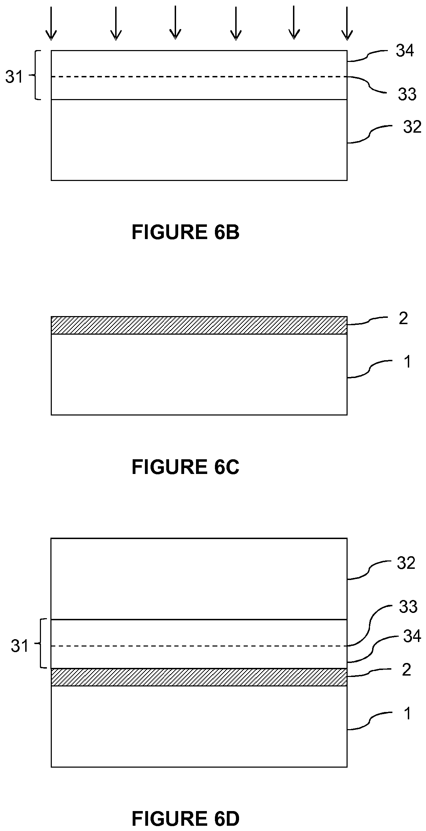

De manière particulièrement avantageuse, comme illustré sur la figure 6B, ladite zone de fragilisation 33 est formée par implantation d'espèces atomiques (typiquement, de l'hydrogène et/ou de l'hélium) au travers de la surface libre de la couche 31 de SiGe. La zone de fragilisation 33 délimite ainsi une couche 34 de SiGe à la surface du substrat donneur.

En référence à la figure 6C, on fournit par ailleurs un substrat receveur comprenant un substrat support 1 et une couche électriquement isolante 2.

En référence à la figure 6D, on colle le substrat donneur sur le substrat receveur, la couche 31 de SiGe et la couche électriquement isolante 2 étant à l'interface de collage.

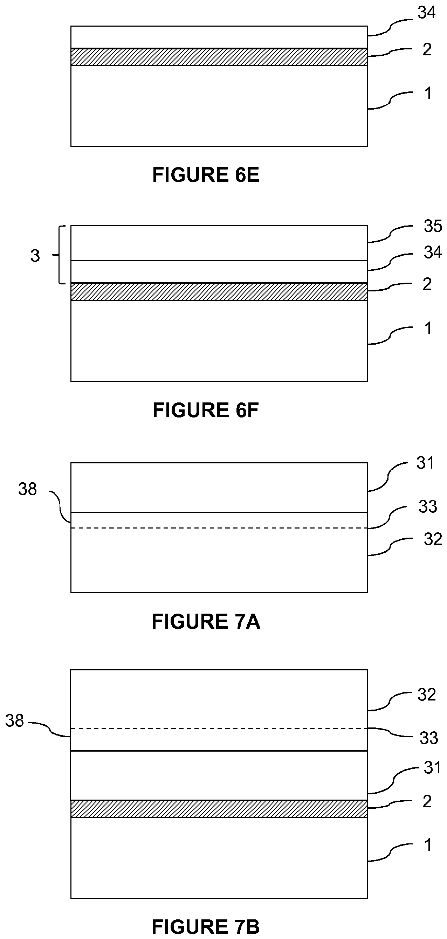

Ensuite, comme illustré sur la figure 6E, on détache le substrat donneur le long de la zone de fragilisation. Ledit détachement peut être initié par toute technique connue de l'homme du métier, telle qu'une contrainte mécanique, chimique, et/ou thermique.

On transfère ainsi la couche 34 de SiGe sur le substrat support.

On procède le cas échéant à un traitement de la surface de la couche de SiGe pour retirer les défauts liés à l'implantation et au détachement, et la rendre suffisamment lisse pour l'étape d'épitaxie qui va suivre.

Dans une seconde version de cet exemple, une zone de fragilisation 33 est formée dans le substrat donneur 30 situé sous la couche 31 de SiGe 31 (cf. figure 7A).

De manière particulièrement avantageuse, ladite zone de fragilisation 33 est formée par implantation d'espèces atomiques (typiquement, de l'hydrogène et/ou de l'hélium) au travers de la surface libre de la couche 30. La zone de fragilisation 33 délimite ainsi une couche de SiGe et d'une portion 38 du substrat de base 32 à la surface du substrat donneur.

En référence à la figure 6C, on fournit par ailleurs un substrat receveur comprenant un substrat support 1 et une couche électriquement isolante 2.

En référence à la figure 7B, on colle le substrat donneur sur le substrat receveur, la couche 31 de SiGe et la couche électriquement isolante 2 étant à l'interface de collage.

Ensuite, on détache le substrat donneur le long de la zone de fragilisation 33. Ledit détachement peut être initié par toute technique connue de l'homme du métier, telle qu'une contrainte mécanique, chimique, et/ou thermique.

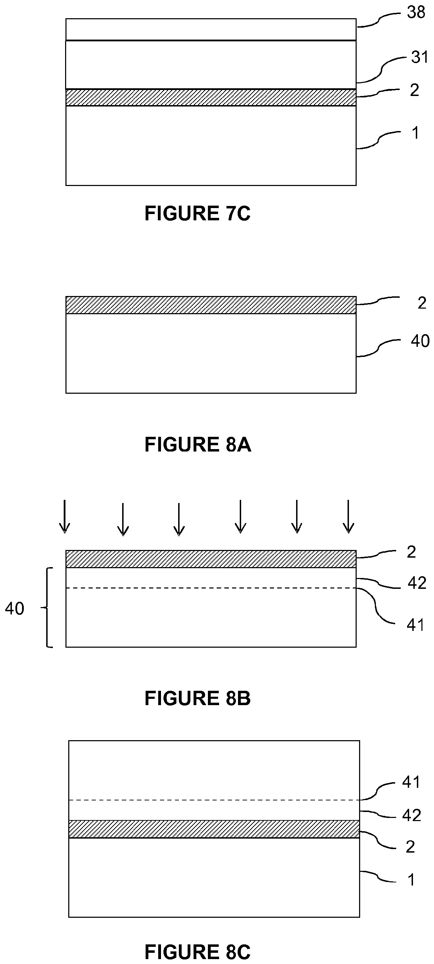

On transfère ainsi la couche 31 de SiGe et la portion 38 du substrat de base sur le substrat support (cf. figure 7C).

On procède alors à un traitement de la surface créée pour retirer la portion 38 du substrat donneur superficielle jusqu'à laisser apparaître une surface de SiGe, retirant ainsi les défauts liés à l'implantation et au détachement, et la rendant suffisamment lisse pour l'étape d'épitaxie qui va suivre.

On obtient ainsi, comme sur la figure 6E, une portion 34 de la couche 31 de SiGe sur le substrat support 1.

Comme illustré sur la figure 6F (étape commune aux deux versions de l'exemple) on procède alors à une reprise d'épitaxie pour faire croître une couche 35 de SiGe sur la couche 34 transférée qui remplit le rôle de couche germe, jusqu'à l'épaisseur souhaitée pour la couche active 3, qui est formée de l'ensemble des deux couches 34 et 35 de SiGe. Lors de l'épitaxie, il est possible de doper légèrement la couche 35, selon les propriétés électriques souhaitées. Le dopage de la couche 35 n'est pas nécessairement identique à celui de la couche germe 34.

On obtient ainsi le substrat illustré sur la figure 2. Selon un mode de réalisation selon l'invention, illustré sur les figures 8A à 8D, on utilise le procédé Smart Cut^{™} bien connu pour former un substrat SOI comprenant le substrat support, la couche électriquement isolante, et une couche germe de silicium destinée à la croissance épitaxiale de la couche de SiGe.

A cet effet, on fournit un substrat donneur 40 de silicium recouvert de la couche électriquement isolante 2 (cf. figure 8A), puis l'on forme par implantation d'espèces atomiques une zone de fragilisation 41 délimitant une couche 42 de silicium à transférer (cf. figure 8B).

On fournit par ailleurs un substrat receveur, qui est typiquement le substrat support 1 du substrat final.

En référence à la figure 8C, on colle le substrat donneur 40 sur le substrat receveur 1, la couche électriquement isolante 2 étant à l'interface de collage.

Ensuite, on détache le substrat donneur le long de la zone de fragilisation. Ledit détachement peut être initié par toute technique connue de l'homme du métier, telle qu'une contrainte mécanique, chimique, et/ou thermique.

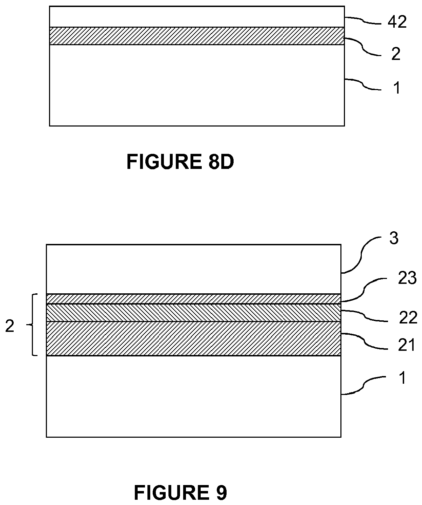

On transfère ainsi la couche 42 de silicium sur le substrat support 1 (cf. figure 8D).

On procède le cas échéant à un traitement de la surface de la couche de silicium pour retirer les défauts liés à l'implantation et au détachement, et la rendre suffisamment lisse pour l'étape d'épitaxie qui va suivre.

On procède alors à une reprise d'épitaxie de SiGe sur la couche 42 de silicium transférée qui sert de couche germe, jusqu'à l'épaisseur souhaitée pour la couche active 3. Lors de l'épitaxie, il est possible de doper légèrement la couche 3, selon les propriétés électriques souhaitées.

On obtient ainsi le substrat illustré sur la figure 5.

Comme mentionné plus haut, la couche germe de silicium peut être conservée pour la formation du capteur d'image. De manière alternative, la couche de silicium peut être retirée au moyen du procédé de condensation susmentionné.

Selon une forme d'exécution particulière de l'invention, la couche électriquement isolante 2 n'est pas, comme dans les substrats SOI conventionnels, une couche d'oxyde de silicium, mais est constituée d'un empilement de couches diélectriques et/ou métalliques choisies de sorte à augmenter la réflectivité de ladite couche électriquement isolante dans l'infrarouge. Plus précisément, les couches diélectriques et/ou métalliques formant cet empilement sont choisies de telle sorte que la réflectivité dudit empilement dans une gamme de longueurs d'onde comprises entre 700 nm et 3 µm soit supérieure à la réflectivité d'une couche d'oxyde de silicium présentant une épaisseur égale à celle dudit empilement. Par ailleurs, une couche métallique de l'empilement est avantageusement séparée du substrat support et de la couche active par au moins une couche diélectrique. Lesdites couches diélectriques assurent donc notamment une fonction d'isolation électrique de la couche active vis-à-vis du substrat support.

Par exemple, comme illustré sur la figure 9, la couche électriquement isolante comprend successivement :
- une première couche 21 d'oxyde de silicium à l'interface avec le substrat support 1,
- une couche 22 de nitrure de titane, et
- une seconde couche 23 d'oxyde de silicium, à l'interface avec la couche active 3.

Le nitrure de titane est un matériau métallique couramment utilisé en microélectronique.

Les couches diélectriques 21 et 23 d'oxyde de silicium permettent d'encapsuler la couche de nitrure de titane et évitent ainsi toute contamination métallique de la couche active. On évite ainsi la génération de défauts électriques à l'interface entre la couche active et la couche électriquement isolante et des recombinaisons entre le SiGe de la couche active et les composants métalliques du capteur, susceptibles de doper la couche active.

Typiquement, la couche 21 présente une épaisseur comprise entre 300 et 500 nm, la couche 23 une épaisseur comprise entre 10 et 50 nm, et la couche 22 une épaisseur comprise entre 10 et 100 nm.

Une telle couche électriquement isolante présente l'avantage de réfléchir davantage les photons transmis au travers de la couche active 3 qu'une couche d'oxyde de silicium d'épaisseur identique.

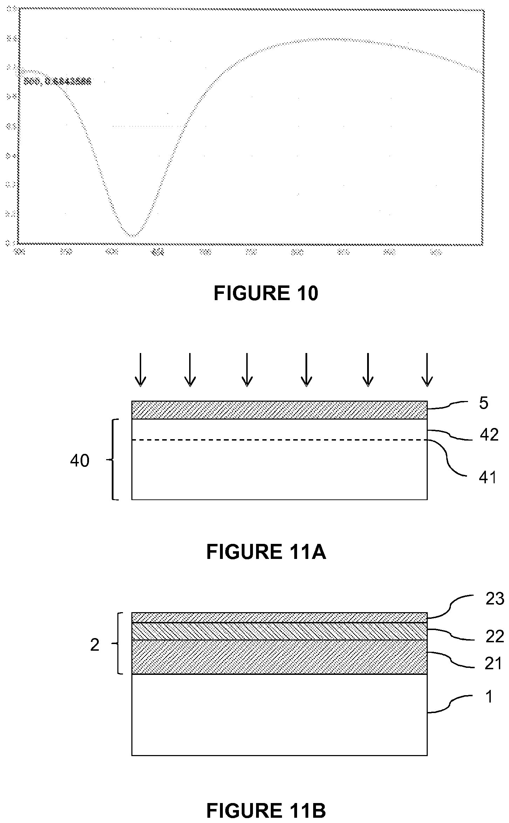

Ceci est visible sur la figure 10, qui présente la réflectivité de l'empilement suivant (du substrat support vers la couche active) en fonction de la longueur d'onde (en nm) :
- la première couche 21 d'oxyde de silicium, de 400 nm d'épaisseur,
- la couche 22 de nitrure de titane, de 50 nm d'épaisseur, et
- la seconde couche 23 d'oxyde de silicium, de 20 nm d'épaisseur.

On obtient ainsi une réflectivité atteignant 0,8 pour une longueur d'onde de 850 nm. A titre de comparaison, une couche de 400 nm d'oxyde de silicium présente une réflectivité de 0,5 pour une longueur d'onde de 850 nm.

Cette réflectivité accrue a pour effet d'augmenter la longueur du trajet des photons au sein de la couche active 3, et ainsi de favoriser leur absorption par ladite couche.

Ainsi, avec l'utilisation simultanée de la couche active de silicium-germanium et de l'empilement de couches diélectriques et/ou métalliques formant la couche électriquement isolante, on combine les effets favorables de ces deux couches sur l'absorption du rayonnement infra-rouge.

Dans ce cas, on adapte le procédé de fabrication du substrat de la manière suivante.

Par rapport aux procédés décrits plus haut, lorsque la couche à transférer (qu'il s'agisse d'une couche de SiGe ou d'une couche de silicium) est délimitée dans le substrat donneur par une zone de fragilisation formée par implantation, on ne forme pas l'empilement de couches diélectriques et/ou métalliques sur le substrat donneur mais sur le substrat support. En effet, un tel empilement serait trop épais pour l'implantation. En revanche, de manière avantageuse, on forme sur le substrat donneur, avant implantation, une couche d'oxyde de silicium sacrificielle au travers de laquelle on implante les espèces atomiques destinées à former la zone de fragilisation. Ladite couche sacrificielle permet d'éviter l'effet de « channeling » lors de l'implantation. Ladite couche sacrificielle est ensuite retirée du substrat donneur avant le collage de celui-ci au substrat support.

Les figures 11A à 11E illustrent un mode de réalisation préféré d'un substrat pour capteur d'image face avant comprenant un tel empilement de couches diélectriques. Les éléments désignés par les mêmes signes de référence que sur les figures précédentes, notamment les figures 8A-8D, désignent les mêmes éléments. Cependant, l'homme du métier pourra également appliquer le procédé ci-dessous au cas où la couche germe transférée est une couche de SiGe comme dans le procédé décrit en référence aux figures 6A-6F ou 7A-7C.

En référence à la figure 11A, on fournit un substrat donneur 40 de silicium recouvert d'une couche sacrificielle 5 d'oxyde de silicium, puis l'on forme par implantation d'espèces atomiques au travers de la couche 5 une zone de fragilisation 41 délimitant une couche 42 de silicium à transférer. Après l'implantation, on retire la couche sacrificielle 5, par exemple par gravure chimique.

En référence à la figure 11B, on fournit par ailleurs un substrat receveur, qui est typiquement le substrat support 1 du substrat final, sur lequel on forme l'empilement de couches 21, 22, 23 destinées à former la couche électriquement isolante 2.

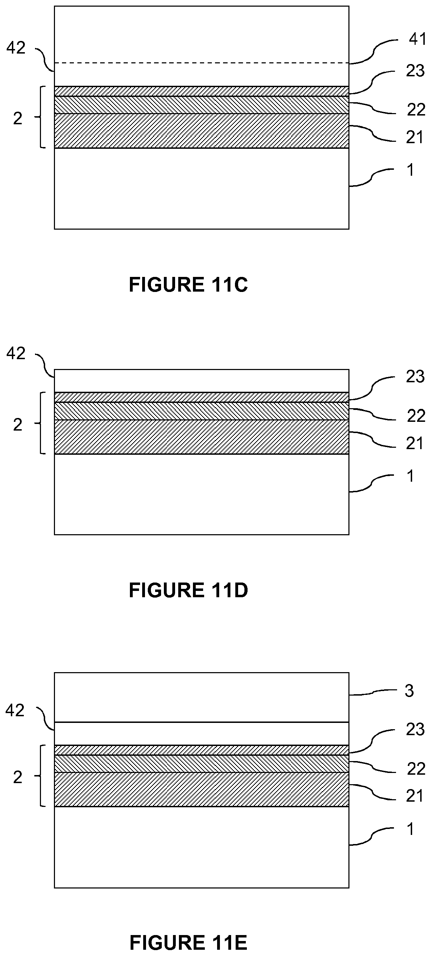

En référence à la figure 11C, on colle le substrat donneur 40 sur le substrat support 1, l'empilement de couches diélectriques et/ou métalliques formant la couche électriquement isolante 2 étant à l'interface de collage.

Ensuite, on détache le substrat donneur le long de la zone de fragilisation 41. Ledit détachement peut être initié par toute technique connue de l'homme du métier, telle qu'une contrainte mécanique, chimique, et/ou thermique.

On transfère ainsi la couche 42 de silicium sur le substrat support 1 (cf. figure 11D).

On procède le cas échéant à un traitement de la surface de la couche de silicium pour retirer les défauts liés à l'implantation et au détachement, et la rendre suffisamment lisse pour l'étape d'épitaxie qui va suivre.

En référence à la figure 11E, on procède alors à une reprise d'épitaxie de SiGe sur la couche 42 de silicium transférée qui sert de couche germe, jusqu'à l'épaisseur souhaitée pour la couche active 3. Lors de l'épitaxie, il est possible de doper légèrement la couche 3, selon les propriétés électriques souhaitées.

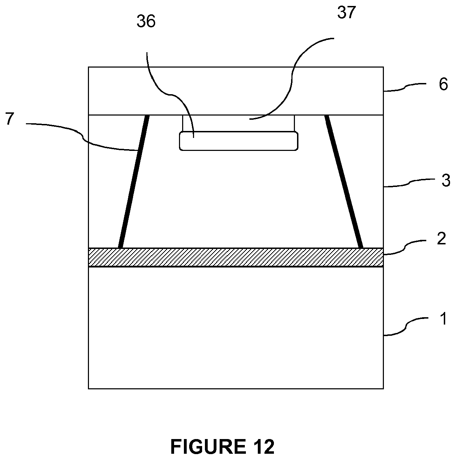

La figure 12 illustre une partie d'un capteur d'image de type face avant comprenant un substrat selon un mode de réalisation de l'invention correspondant à la figure 2, mais non limité à celui-ci. Seule une partie du capteur correspondant à un pixel est représentée sur cette figure, ledit pixel étant isolé électriquement des autres pixels formés dans la couche active 3 par des tranchées d'isolation 7.

Une région 36 dopée de type différent de celui de la couche 3 est formée sous la surface de la face avant de la couche active 3. Cette région 36 forme avec la couche active 3 une photodiode. Une région 37 formée entre la région 36 et la face avant de la couche 3 présente avantageusement un niveau de dopage supérieur à celui de la région 36 afin de passiver l'interface. Une couche de passivation 6 est formée sur la couche active 3 et peut encapsuler des éléments permettant de contrôler électriquement ledit pixel.

Eventuellement, d'autres couches, tels que des filtres, peuvent être formées sur la couche de passivation 6, mais elles ne sont pas représentées sur la figure 12.

La structure du capteur d'image en tant que tel et son procédé de fabrication sont connus de l'homme du métier et ne seront donc pas décrits en détail ici.

### REFERENCES

US 2016/0118431
WO 2005/043614

## Revendications

1. Procédé de fabrication d'un substrat pour un capteur d'image de type face avant, comprenant les étapes suivantes :
- fourniture d'un substrat donneur (40) comprenant un matériau semi-conducteur adapté pour la croissance épitaxiale de silicium-germanium, ledit matériau semi-conducteur étant du silicium ;
- formation d'une zone de fragilisation (41) dans le substrat donneur (40) par implantation d'espèces atomiques dans le substrat donneur (40) de sorte à délimiter une couche (42) de silicium ;
- fourniture d'un substrat support (1) ;
- collage du substrat donneur (40) sur le substrat support (1), une couche électriquement isolante (2) étant à l'interface de collage ;
- détachement du substrat donneur (40) selon ladite zone de fragilisation (41) de sorte à transférer la couche (42) de silicium sur le substrat support (1) ;
- croissance épitaxiale de silicium-germanium sur la couche (42) de silicium transférée qui sert de couche germe de sorte à obtenir sur la couche (42) de silicium transférée une couche (3) de silicium-germanium présentant une épaisseur supérieure à 1 µm, la teneur en germanium de ladite couche étant inférieure ou égale à 8%.

2. Procédé selon la revendication 1, dans lequel, à l'issue de la croissance épitaxiale de silicium-germanium, la couche (42) de silicium transférée est conservée entre la couche électriquement isolante (2) et la couche (3) de silicium-germanium.

3. Procédé selon la revendication 2, comprenant en outre une étape de condensation du silicium-germanium de la couche (3) de silicium-germanium de sorte à convertir la couche (42) de silicium transférée à partir de laquelle la croissance épitaxiale de silicium-germanium a été effectuée en une couche de silicium-germanium.

4. Procédé selon l'une des revendications 1 à 3, dans lequel la couche électriquement isolante est formée par dépôt, sur le substrat support (1), d'un empilement de couches diélectriques et/ou métalliques (21, 22, 23) choisies de telle sorte que la réflectivité dudit empilement dans une gamme de longueurs d'onde comprises entre 700 nm et 3 µm soit supérieure à la réflectivité d'une couche d'oxyde de silicium présentant une épaisseur égale à celle dudit empilement.

5. Procédé selon la revendication 4, dans lequel on forme une couche d'oxyde (5) sacrificielle sur le substrat donneur (40) avant l'implantation des espèces atomiques, l'implantation des espèces atomiques étant réalisée au travers de ladite couche sacrificielle (5), ladite couche d'oxyde sacrificielle (5) étant retirée avant le collage du substrat donneur (40) sur le substrat support (1).

## Patentansprüche

1. Verfahren zur Herstellung eines Substrats für einen Bildsensor vom Frontseitentyp, das die folgenden Schritte umfasst:
- Bereitstellen eines Donorsubstrats (40), das ein Halbleitermaterial umfasst, das für das epitaxiale Wachstum von Silizium-Germanium geeignet ist, wobei das Halbleitermaterial Silizium ist;
- Bilden einer Schwächungszone (41) im Donorsubstrat (40) durch Implantation von atomaren Spezies im Donorsubstrat (40) zur Abgrenzung einer Siliziumschicht (42);
- Bereitstellen eines Trägersubstrats (1);
- Kleben des Donorsubstrats (40) auf das Trägersubstrat (1), wobei eine elektrisch isolierende Schicht (2) an der Klebeschnittstelle liegt;
- Entfernen des Donorsubstrats (40) gemäß der Schwächungszone (41), so dass die Siliziumschicht (42) auf das Trägersubstrat (1) übertragen wird;
- epitaxiales Wachsen von Silizium-Germanium auf der übertragenen Siliziumschicht (42), die als Keimschicht dient, so dass auf der übertragenen Siliziumschicht (42) eine Silizium-Germanium-Schicht (3) mit einer Dicke von über 1 µm erhalten wird, wobei der Germaniumgehalt der Schicht 8 % oder weniger beträgt.

2. Verfahren nach Anspruch 1, wobei nach dem epitaxialen Wachstum von Silizium-Germanium die übertragene Siliziumschicht (42) zwischen der elektrisch isolierenden Schicht (2) und der Silizium-Germanium-Schicht (3) beibehalten wird.

3. Verfahren nach Anspruch 2, ferner umfassend einen Kondensationsschritt des Silizium-Germaniums der Silizium-Germanium-Schicht (3), so dass die übertragene Siliziumschicht (42), von der aus das epitaxiale Wachstum von Silizium-Germanium erfolgte, in eine Silizium-Germanium-Schicht umgewandelt wird.

4. Verfahren nach einem der Ansprüche 1 bis 3, wobei die elektrisch isolierende Schicht auf dem Trägersubstrat (1) durch Ablagern eines Stapels dielektrischer und/oder metallischer Schichten (21, 22, 23) gebildet wird, die derart ausgewählt sind, dass die Reflektivität des Stapels in einem Wellenlängenbereich zwischen 700 nm und 3 µm größer ist als die Reflektivität einer Siliziumoxidschicht ist, die eine Dicke aufweist, die gleich der des Stapels ist.

5. Verfahren nach Anspruch 4, wobei auf dem Donorsubstrat (40) vor der Implantation der atomaren Spezies eine Opferoxidschicht (5) gebildet wird, wobei die Implantation der atomaren Spezies durch die Opferschicht (5) erfolgt, wobei die Opferoxidschicht (5) vor dem Kleben des Donorsubstrats (40) auf das Trägersubstrat (1) entfernt wird.

## Claims

1. Method of manufacturing a substrate for a front side type image sensor, comprising the following steps:
- providing a donor substrate (40) comprising a semiconductor material suitable for epitaxial growth of silicon-germanium, said semiconductor material being silicon;
- forming an embrittlement zone (33, 41) by implantation of atomic species in the donor substrate (40) so as to define a layer (42) of silicon;
- providing a support substrate (1);
- bonding the donor substrate (40) to the support substrate (1), with an electrically insulating layer (2) at the bonding interface;
- detaching the donor substrate (40) according to said embrittlement zone (41) so as to transfer the silicon layer (42) onto the support substrate (1);
- epitaxially growing silicon-germanium on the transferred silicon layer (42) which serves as a seed layer so as to obtain on the transferred silicon layer (42) a silicon-germanium layer (3) with a thickness greater than 1 µm, the germanium content of said layer being less than or equal to 8%.

2. Method according to claim 1, wherein after the silicon-germanium epitaxial growth, the silicon layer (42) is retained between the electrically insulating layer (2) and the silicon-germanium layer (3).

3. Method according to claim 2, further comprising a step of condensing the silicon-germanium of the active layer (3) so as to convert the silicon layer (42) from which the silicon-germanium epitaxial growth was performed into a silicon-germanium layer.

4. Method according to one of claims 1 to 3, wherein the electrically insulating layer is formed by depositing, on the support substrate (1), a stack of dielectric and/or metallic layers (21, 22, 23) selected such that the reflectivity of said stack in a wavelength range between 700 nm and 3 µm is greater than the reflectivity of a silicon oxide layer having a thickness equal to that of said stack.

5. Method according to claim 4, wherein a sacrificial oxide layer (5) is formed on the donor substrate (40) prior to implantation of the atomic species, the implantation of the atomic species being performed through said sacrificial layer (5), said sacrificial oxide layer (5) being removed prior to bonding the donor substrate (30, 40) to the support substrate (1).
